# EUROPEAN PATENT SPECIFICATION

(11) **EP 2 661 458 B1**
(45) Date of publication and mention of the grant of the patent: **16.09.2015**
(21) Application number: 12702626.8
(22) Date of filing: 03.01.2012
(51) Int. Cl.: B29C 44/18, C08J 5/18, C08J 9/35, B29D 7/01, B32B 1/06, B32B 3/20, B81B 1/00

(54) **MICROCAPILLARY FILMS AND FOAMS CONTAINING FUNCTIONAL FILLER MATERIALS**
MIKROKAPILLARE FOLIEN UND SCHAUMSTOFFE MIT FUNKTIONELLEN FÜLLSTOFFEN
FILMS ET MOUSSES MICROCAPILLAIRES CONTENANT DES MATIÈRES DE CHARGE FONCTIONNELLES

(30) Priority: 03.01.2011 US 201161429347 P
(43) Date of publication of application: 13.11.2013
(73) Proprietor: Dow Global Technologies LLC, Midland, MI 48674 (US)
(72) Inventor: KOOPMANS, Rudolf J., CH-8840 Einsiedeln (CH); ZALAMEA BUSTILLO, Luis G., CH-8805 Richterswil (CH); BONGARTZ, Herbert, CH-8840 Einsiedeln (CH)
(74) Representative: Boult Wade Tennant
(86) International application number: PCT/US2012/020076
(87) International publication number: WO 2012/094315

(56) References cited:
- WO-A1-00/68001
- DD-A1- 153 580
- DE-A1- 19 842 956
- US-A- 3 503 840
- US-A1- 2003 104 192

## Description

### Field of Invention

The instant invention relates to microcapillary films and/or foams containing functional filler materials.

### Background of the Invention

The use of functional filler materials in various applications is generally known; however, such various applications require further improvements, for example, in the areas of absorption, heat conductions, electro-magnetic responsiveness, color control, and/or bioactive responsiveness.

Despite the research efforts in providing improved use of functional fillers, there is a still a need for a system which provides for an efficient way to pack large quantities of functional filler materials while maintaining other efficient properties such as absorption, heat conductions, electromagnetic responsiveness, color control, and/or bioactive responsiveness.

### Summary of the Invention

The instant invention provides microcapillary films and /or foams containing one or more functional filler materials. The inventive microcapillary film and/or foam containing one or more functional filler materials according to the present invention has a film or foam having a first end and a second end and a length extending between the first and second ends and having a thickness smaller than the length, wherein said film comprises:
(a) a matrix comprising a thermoplastic material,
(b) at least more than one channel disposed in parallel to the length in said matrix from the first end to the second end of said film, wherein said channels are at least 1 µm apart from each other, and wherein each said channels have a diameter in the range of at least 1 µm and less than 1998 µm; and
(c) one or more functional filler materials inserted in said channels;
wherein the thickness is from 2 µm to 2000 µm; and
wherein the one or more functional filler materials are selected from the group consisting of bioactive fillers, electrical and/or magnetically active fillers, organic-inorganic hybrids, surface property modifiers, wettability promoters, solid and/or liquid flame retardants and superabsorbent polymers.

In an alternative embodiment, the instant invention provides microcapillary films and/or foams containing one or more functional filler materials, in accordance with any of the preceding embodiments, except that the thermoplastic material is selected from the group consisting of polyolefin, e.g. polyethylene and polypropylene; polyamide, e.g. nylon 6; polyvinylidene chloride; polyvinylidene fluoride; polycarbonate; polystyrene; polyethylene terephthalate; polyurethane and/or polyester

In an alternative embodiment, the instant invention provides microcapillary films and /or foams containing one or more functional filler materials, in accordance with any of the preceding embodiments, except that the one or more channels have a cross sectional shape selected from the group consisting of circular, rectangular, oval, star, dimond, triangular, square, the like, and combinations thereof.

In an alternative embodiment, the instant invention provides microcapillary films and /or foams containing one or more functional filler materials, in accordance with any of the preceding embodiments.

### Brief Description of the Drawings

For the purpose of illustrating the invention, there is shown in the drawings a form that is exemplary; it being understood, however, that this invention is not limited to the precise arrangements and instrumentalities shown.
**Fig. 1** is a top view of an inventive microcapillary film or foam containing one or more functional filler materials;
**Fig. 2** is a longitudinal-sectional view of an inventive microcapillary film or foam containing one or more functional filler materials;
**Fig. 3a-e** are various cross-sectional views of an inventive microcapillary film or foam containing one or more functional filler materials;
**Fig. 4** is an elevated view of an inventive microcapillary film or foam containing one or more functional filler materials;
**Fig. 5** is a segment of a longitudinal sectional view of the inventive microcapillary film or foam containing one or more functional filler materials, as shown in figure 2;
**Fig. 6** is an exploded view of an inventive microcapillary film or foam containing one or more functional filler materials; and
**Figs. 7a****-b** are schematic illustration of a microcapillary die.

### Detailed Description of the Invention

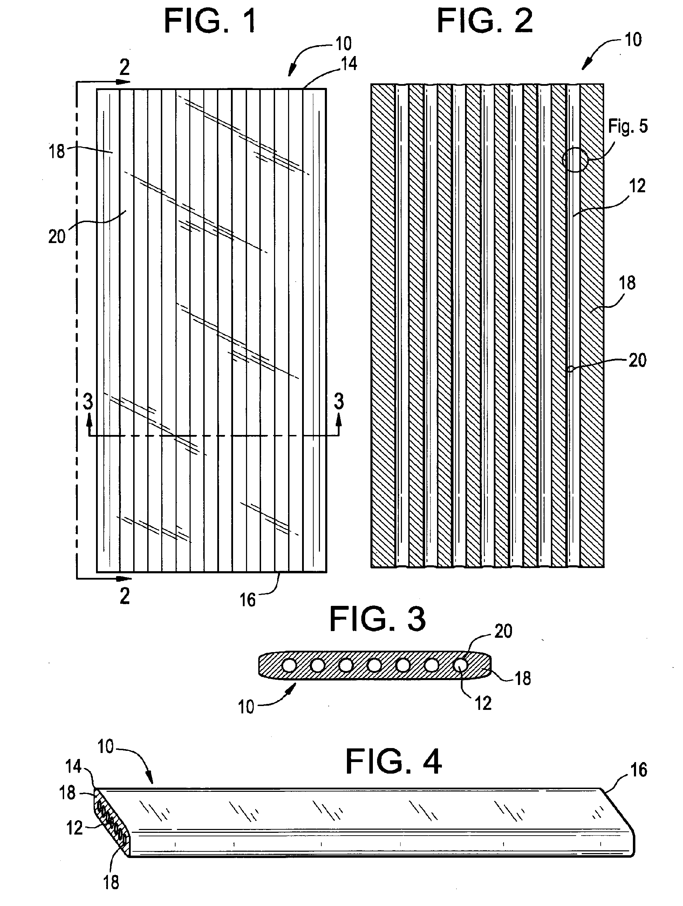

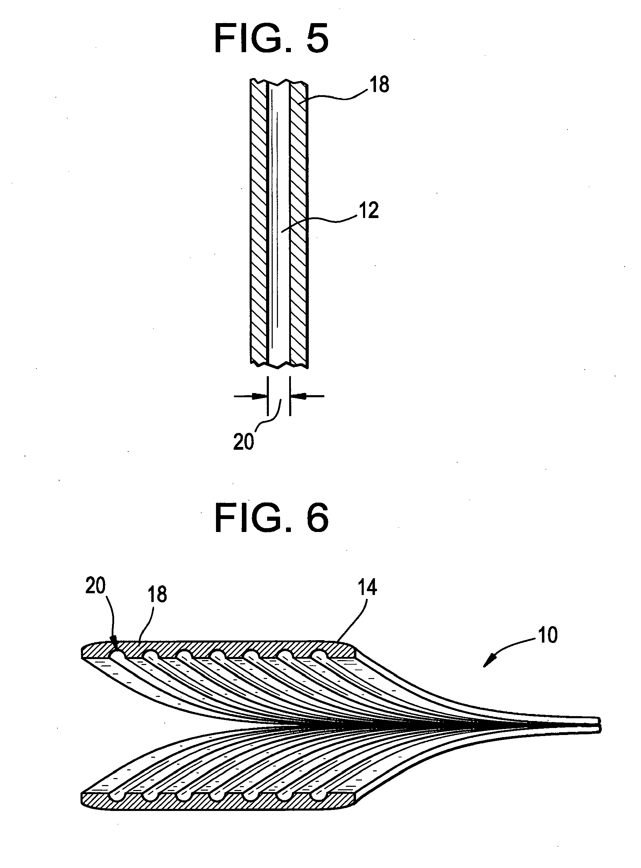

Referring to the drawings wherein like numerals indicate like elements, there is shown, in figures 1-6, a first embodiment of a microcapillary film or foam (10) containing one or more functional filler materials (12).

The inventive microcapillary film or foam (10) containing one or more functional filler materials (12) according to the present invention has a first end (14) and a second end (16), and comprises: (a) a matrix (18) comprising a thermoplastic material; (b) at least one or more channels (20) disposed in parallel in said matrix (18) from the first end (14) to the second end (16) of said microcapillary film or foam (10), wherein said one or more channels (20) are at least 1 µm apart from each other, and wherein each said one or more channels (20) have a diameter in the range of at least 1 µm; and (c) at least one or more functional filler materials (12) disposed in said one or more channels (20); wherein said microcapillary film (10) has a thickness in the range of from 2 µm to 2000 µm.

The microcapillary film or foam (10) containing functional filler materials (12) has a thickness in the range of from 2 µm to 2000 µm; for example, microcapillary film or foam (10) containing functional filler materials (12) has a thickness in the range of from 2 to 2000 µm; or in the alternative, from 10 to 1000 µm; or in the alternative, from 200 to 800 µm; or in the alternative, from 200 to 600 µm; or in the alternative, from 300 to 1000 µm; or in the alternative, from 300 to 900 µm; or in the alternative, from 300 to 700 µm. The film thickness to microcapillary diameter ratio is in the range of from 2:1 to 400:1. The term "microcapillary film," as used herein refers to films as well as tapes.

The microcapillary film or foam (10) containing one or more functional filler materials (12) may comprise at least 10 percent by volume of the matrix (18), based on the total volume of the microcapillary film or foam (10) containing one or more functional filler materials (12); for example, the microcapillary film or foam (10) containing one or more functional filler materials (12) may comprise from 10 to 80 percent by volume of the matrix (18), based on the total volume of the microcapillary film or foam (10) containing one or more functional filler materials (12); or in the alternative, from 20 to 80 percent by volume of the matrix (18), based on the total volume of the microcapillary film or foam (10) containing one or more functional filler materials (12); or in the alternative, from 30 to 80 percent by volume of the matrix (18), based on the total volume of the microcapillary film or foam (10) containing one or more functional filler materials (12).

The microcapillary film or foam (10) containing one or more functional filler materials (12) may comprise from 20 to 90 percent by volume of voidage, based on the total volume of the microcapillary film or foam (10) containing one or more functional filler materials (12); for example, the microcapillary film or foam (10) containing one or more functional filler materials (12) may comprise from 20 to 80 percent by volume of voidage, based on the total volume of the microcapillary film or foam (10) containing one or more functional filler materials (12); or in the alternative, from 20 to 70 percent by volume of voidage, based on the total volume of the microcapillary film or foam (10) containing one or more functional filler materials (12); or in the alternative, from 30 to 60 percent by volume of voidage, based on the total volume of the microcapillary film or foam (10) containing one or more functional filler materials (12).

The microcapillary film or foam (10) containing one or more functional filler materials (12) may comprise from 50 to 100 percent by volume of the one or more functional filler materials (12), based on the total voidage volume, described above; for example, the microcapillary film or foam (10) containing one or more functional filler materials (12) may comprise from 60 to 100 percent by volume of the one or more functional filler materials (12), based on the total voidage volume, described above; or in the alternative, from 70 to 100 percent by volume of the one or more functional filler materials (12), based on the total voidage volume, described above; or in the alternative, from 80 to 100 percent by volume of the one or more functional filler materials (12), based on the total voidage volume, described above.

The inventive microcapillary film or foam (10) containing one or more functional filler materials (12) has a first end (14) and a second end (16). At least one or more channels (20) are disposed in parallel in the matrix (18) from the first end (14) to the second end (16). The one or more channels (20) are at least 1 µm apart from each other. The one or more channels (20) have a diameter in the range of from 1 µm to 1998 µm; or in the alternative, from 5 to 990 µm; or in the alternative, from 5 to 890 µm; or in the alternative, from 5 to 790 µm; or in the alternative, from 5 to 690 µm or in the alternative, from 5 to 590 µm. The one or more channels (20) may have a cross-sectional shape selected from the group consisting of circular, rectangular, oval, star, diamond, triangular, square, the like, and combinations thereof. The one or more channels (20) may further include one or more seals at the first end (14), the second end (16), therebetween the first point (14) and the second end (16), and/or combinations thereof.

The inventive microcapillary film or foam (10) containing one or more functional filler materials (12) may further be surface treated via, for example, corona surface treatment, plasma surface treatment, flame surface treatment, and/or chemical grafting surface treatment.

The matrix (18) comprises one or more thermoplastic materials. Such thermoplastic materials include, but are not limited to, polyolefin, e.g. polyethylene and polypropylene; polyamide, e.g. nylon 6; polyvinylidene chloride; polyvinylidene fluoride; polycarbonate; polystyrene; polyethylene terephthalate; polyester, and polyurethanes. The matrix (18) may be reinforced via, for example, glass or carbon fibers and/or any other mineral fillers such talc or calcium carbonate. Exemplary fillers include, but are not limited to, natural calcium carbonates, including chalks, calcites and marbles, synthetic carbonates, salts of magnesium and calcium, dolomites, magnesium carbonate, zinc carbonate, lime, magnesia, barium sulphate, barite, calcium sulphate, silica, magnesium silicates, talc, wollastonite, clays and aluminium silicates, kaolins, mica, oxides or hydroxides of metals or alkaline earths, magnesium hydroxide, iron oxides, zinc oxide, glass or carbon fiber or powder, wood fiber or powder or mixtures of these compounds.

Examples of thermoplastic materials include, but are not limited to, homopolymers and copolymers (including elastomers) of one or more alpha-olefins such as ethylene, propylene, 1-butene, 3-methyl-1-butene, 4-methyl-1-pentene, 3-methyl-1-pentene, 1-heptene, 1-hexene, 1-octene, 1-decene, and 1-dodecene, as typically represented by polyethylene, polypropylene, poly-1-butene, poly-3-methyl-1-butene, poly-3-methyl-1-pentene, poly-4-methyl-1-pentene, ethylene-propylene copolymer, ethylene-1-butene copolymer, and propylene-1-butene copolymer; copolymers (including elastomers) of an alpha-olefin with a conjugated or non-conjugated diene, as typically represented by ethylene-butadiene copolymer and ethylene-ethylidene norbornene copolymer; and polyolefins (including elastomers) such as copolymers of two or more alpha-olefins with a conjugated or non-conjugated diene, as typically represented by ethylene-propylene-butadiene copolymer, ethylene-propylene- dicyclopentadiene copolymer, ethylene-propylene-1,5-hexadiene copolymer, and ethylene-propylene-ethylidene norbornene copolymer; ethylene-vinyl compound copolymers such as ethylene-vinyl acetate copolymer, ethylene-vinyl alcohol copolymer, ethylene-vinyl chloride copolymer, ethylene acrylic acid or ethylene-(meth)acrylic acid copolymers, and ethylene-(meth)acrylate copolymer; styrenic copolymers (including elastomers) such as polystyrene, ABS, acrylonitrile-styrene copolymer, α-methylstyrene-styrene copolymer, styrene vinyl alcohol, styrene acrylates such as styrene methylacrylate, styrene butyl acrylate, styrene butyl methacrylate, and styrene butadienes and crosslinked styrene polymers; and styrene block copolymers (including elastomers) such as styrene-butadiene copolymer and hydrate thereof, and styrene-isoprene-styrene triblock copolymer; polyvinyl compounds such as polyvinyl chloride, polyvinylidene chloride, vinyl chloride-vinylidene chloride copolymer, polymethyl acrylate, and polymethyl methacrylate; polyamides such as nylon 6, nylon 6,6, and nylon 12; thermoplastic polyesters such as polyethylene terephthalate and polybutylene terephthalate; polyurethane; polycarbonate, polyphenylene oxide, and the like; and glassy hydrocarbon-based resins, including poly-dicyclopentadiene polymers and related polymers (copolymers, terpolymers); saturated mono-olefins such as vinyl acetate, vinyl propionate, vinyl versatate, and vinyl butyrate and the like; vinyl esters such as esters of monocarboxylic acids, including methyl acrylate, ethyl acrylate, n-butyl acrylate, isobutyl acrylate, 2-ethylhexyl acrylate, dodecyl acrylate, n-octyl acrylate, phenyl acrylate, methyl methacrylate, ethyl methacrylate, and butyl methacrylate and the like; acrylonitrile, methacrylonitrile, acrylamide, mixtures thereof; resins produced by ring opening metathesis and cross metathesis polymerization and the like. These resins may be used either alone or in combinations of two or more.

In selected embodiments, thermoplastic material may, for example, comprise one or more polyolefins selected from the group consisting of ethylene-alpha olefin copolymers, propylene-alpha olefin copolymers, and olefin block copolymers. In particular, in select embodiments, the thermoplastic material may comprise one or more non-polar polyolefins.

In specific embodiments, polyolefins such as polypropylene, polyethylene, copolymers thereof, and blends thereof, as well as ethylene-propylene-diene terpolymers, may be used. In some embodiments, exemplary olefinic polymers include homogeneous polymers; high density polyethylene (HDPE); heterogeneously branched linear low density polyethylene (LLDPE); heterogeneously branched ultra low linear density polyethylene (ULDPE); homogeneously branched, linear ethylene/alpha-olefin copolymers; homogeneously branched, substantially linear ethylene/alpha-olefin polymers; and high pressure, free radical polymerized ethylene polymers and copolymers such as low density polyethylene (LDPE) or ethylene vinyl acetate polymers (EVA).

In one embodiment, the ethylene-alpha olefin copolymer may, for example, be ethylene-butene, ethylene-hexene, or ethylene-octene copolymers or interpolymers. In other particular embodiments, the propylene-alpha olefin copolymer may, for example, be a propylene-ethylene or a propylene-ethylene-butene copolymer or interpolymer.

In certain other embodiments, the thermoplastic material may, for example, be a semi-crystalline polymer and may have a melting point of less than 110°C. In another embodiment, the melting point may be from 25 to 100°C. In another embodiment, the melting point may be between 40 and 85°C.

In one particular embodiment, the thermoplastic material is a propylene/α-olefin interpolymer composition comprising a propylene/alpha-olefin copolymer, and optionally one or more polymers, e.g. a random copolymer polypropylene (RCP). In one particular embodiment, the propylene/alpha-olefin copolymer is characterized as having substantially isotactic propylene sequences. "Substantially isotactic propylene sequences" means that the sequences have an isotactic triad (mm) measured by ¹³C NMR of greater than 0.85; in the alternative, greater than 0.90; in another alternative, greater than 0.92; and in another alternative, greater than 0.93. Isotactic triads are well-known in the art and are described in, for example, U.S. Patent No. 5,504,172 and International Publication No. WO 00/01745, which refer to the isotactic sequence in terms of a triad unit in the copolymer molecular chain determined by ¹³C NMR spectra.

The propylene/alpha-olefin copolymer may have a melt flow rate in the range of from 0.1 to 500 g/10 minutes, measured in accordance with ASTM D-1238 (at 230°C/2.16 Kg). All individual values and subranges from 0.1 to 500 g/10 minutes are included herein and disclosed herein; for example, the melt flow rate can be from a lower limit of 0.1 g/10 minutes, 0.2 g/10 minutes, or 0.5 g/10 minutes to an upper limit of 500 g/10 minutes, 200 g/10 minutes, 100 g/10 minutes, or 25 g/10 minutes. For example, the propylene/alpha-olefin copolymer may have a melt flow rate in the range of from 0.1 to 200 g/10 minutes; or in the alternative, the propylene/alpha-olefin copolymer may have a melt flow rate in the range of from 0.2 to 100 g/10 minutes; or in the alternative, the propylene/alpha-olefin copolymer may have a melt flow rate in the range of from 0.2 to 50 g/10 minutes; or in the alternative, the propylene/alpha-olefin copolymer may have a melt flow rate in the range of from 0.5 to 50 g/10 minutes; or in the alternative, the propylene/alpha-olefin copolymer may have a melt flow rate in the range of from 1 to 50 g/10 minutes; or in the alternative, the propylene/alpha-olefin copolymer may have a melt flow rate in the range of from 1 to 40 g/10 minutes; or in the alternative, the propylene/alpha-olefin copolymer may have a melt flow rate in the range of from 1 to 30 g/10 minutes.

The propylene/alpha-olefin copolymer has a crystallinity in the range of from at least 1 percent by weight (a heat of fusion of at least 2 Joules/gram) to 30 percent by weight (a heat of fusion of less than 50 Joules/gram). All individual values and subranges from 1 percent by weight (a heat of fusion of at least 2 Joules/gram) to 30 percent by weight (a heat of fusion of less than 50 Joules/gram) are included herein and disclosed herein; for example, the crystallinity can be from a lower limit of 1 percent by weight (a heat of fusion of at least 2 Joules/gram), 2.5 percent (a heat of fusion of at least 4 Joules/gram), or 3 percent (a heat of fusion of at least 5 Joules/gram) to an upper limit of 30 percent by weight (a heat of fusion of less than 50 Joules/gram), 24 percent by weight (a heat of fusion of less than 40 Joules/gram), 15 percent by weight (a heat of fusion of less than 24.8 Joules/gram) or 7 percent by weight (a heat of fusion of less than 11 Joules/gram). For example, the propylene/alpha-olefin copolymer may have a crystallinity in the range of from at least 1 percent by weight (a heat of fusion of at least 2 Joules/gram) to 24 percent by weight (a heat of fusion of less than 40 Joules/gram); or in the alternative, the propylene/alpha-olefin copolymer may have a crystallinity in the range of from at least 1 percent by weight (a heat of fusion of at least 2 Joules/gram) to 15 percent by weight (a heat of fusion of less than 24.8 Joules/gram); or in the alternative, the propylene/alpha-olefin copolymer may have a crystallinity in the range of from at least 1 percent by weight (a heat of fusion of at least 2 Joules/gram) to 7 percent by weight (a heat of fusion of less than 11 Joules/gram); or in the alternative, the propylene/alpha-olefin copolymer may have a crystallinity in the range of from at least 1 percent by weight (a heat of fusion of at least 2 Joules/gram) to 5 percent by weight (a heat of fusion of less than 8.3 Joules/gram). The crystallinity is measured via DSC method. The propylene/alpha-olefin copolymer comprises units derived from propylene and polymeric units derived from one or more alpha-olefin comonomers. Exemplary comonomers utilized to manufacture the propylene/alpha-olefin copolymer are C₂, and C₄ to C₁₀ alpha-olefins; for example, C₂, C₄, C₆ and C₈ alpha-olefins.

The propylene/alpha-olefin copolymer comprises from 1 to 40 percent by weight of one or more alpha-olefin comonomers. All individual values and subranges from 1 to 40 weight percent are included herein and disclosed herein; for example, the comonomer content can be from a lower limit of 1 weight percent, 3 weight percent, 4 weight percent, 5 weight percent, 7 weight percent, or 9 weight percent to an upper limit of 40 weight percent, 35 weight percent, 30 weight percent, 27 weight percent, 20 weight percent, 15 weight percent, 12 weight percent, or 9 weight percent. For example, the propylene/alpha-olefin copolymer comprises from 1 to 35 percent by weight of one or more alpha-olefin comonomers; or in the alternative, the propylene/alpha-olefin copolymer comprises from 1 to 30 percent by weight of one or more alpha-olefin comonomers; or in the alternative, the propylene/alpha-olefin copolymer comprises from 3 to 27 percent by weight of one or more alpha-olefin comonomers; or in the alternative, the propylene/alpha-olefin copolymer comprises from 3 to 20 percent by weight of one or more alpha-olefin comonomers; or in the alternative, the propylene/alpha-olefin copolymer comprises from 3 to 15 percent by weight of one or more alpha-olefin comonomers.

The propylene/alpha-olefin copolymer has a molecular weight distribution (MWD), defined as weight average molecular weight divided by number average molecular weight (M_{w}/Mₙ) of 3.5 or less; in the alternative 3.0 or less; or in another alternative from 1.8 to 3.0.

Such propylene/alpha-olefin copolymers are further described in details in the U.S. Patent Nos. 6,960,635 and 6,525,157. Such propylene/alpha-olefin copolymers are commercially available from The Dow Chemical Company, under the tradename VERSIFY™, or from ExxonMobil Chemical Company, under the tradename VISTAMAXX™.

In one embodiment, the propylene/alpha-olefin copolymers are further characterized as comprising (A) between 60 and less than 100, preferably between 80 and 99 and more preferably between 85 and 99, weight percent units derived from propylene, and (B) between greater than zero and 40, preferably between 1 and 20, more preferably between 4 and 16 and even more preferably between 4 and 15, weight percent units derived from at least one of ethylene and/or a C₄₋₁₀ α-olefin; and containing an average of at least 0.001, preferably an average of at least 0.005 and more preferably an average of at least 0.01, long chain branches/1000 total carbons. The maximum number of long chain branches in the propylene/alpha-olefin copolymer is not critical, but typically it does not exceed 3 long chain branches/1000 total carbons. The term long chain branch, as used herein with regard to propylene/alpha-olefin copolymers, refers to a chain length of at least one (1) carbon more than a short chain branch, and short chain branch, as used herein with regard to propylene/alpha-olefin copolymers, refers to a chain length of two (2) carbons less than the number of carbons in the comonomer. For example, a propylene/1-octene interpolymer has backbones with long chain branches of at least seven (7) carbons in length, but these backbones also have short chain branches of only six (6) carbons in length. Such propylene/alpha-olefin copolymers are further described in details in the U.S. Provisional Patent Application No. 60/988,999 and International Patent Application No. PCT/US08/082599.

In certain other embodiments, the thermoplastic material, e.g. propylene/alpha-olefin copolymer, may, for example, be a semi-crystalline polymer and may have a melting point of less than 110°C. In preferred embodiments, the melting point may be from 25 to 100°C. In more preferred embodiments, the melting point may be between 40 and 85°C.

In other selected embodiments, olefin block copolymers, e.g., ethylene multi-block copolymer, such as those described in the International Publication No. WO2005/090427 and U.S. Patent Application Publication No. US 2006/0199930 describing such olefin block copolymers and the test methods for measuring those properties listed below for such polymers, may be used as the thermoplastic material. Such olefin block copolymer may be an ethylene/α-olefin interpolymer:
(a) having a M_{w}/Mₙ from 1.7 to 3.5, at least one melting point, Tₘ, in degrees Celsius, and a density, d, in grams/cubic centimeter, wherein the numerical values of Tₘ and d corresponding to the relationship:
   Tₘ > -2002.9 + 4538.5(d) - 2422.2(d)²; or
(b) having a M_{w}/Mₙ from 1.7 to 3.5, and being characterized by a heat of fusion, ΔH in J/g, and a delta quantity, ΔT, in degrees Celsius defined as the temperature difference between the tallest DSC peak and the tallest CRYSTAF peak, wherein the numerical values of ΔT and ΔH having the following relationships:
   ΔT > -0.1299(ΔH) + 62.81 for ΔH greater than zero and up to 130 J/g,
   ΔT > 48°C for ΔH greater than 130 J/g,
   wherein the CRYSTAF peak being determined using at least 5 percent of the cumulative polymer, and if less than 5 percent of the polymer having an identifiable CRYSTAF peak, then the CRYSTAF temperature being 30°C; or
(c) being characterized by an elastic recovery, Re, in percent at 300 percent strain and 1 cycle measured with a compression-molded film of the ethylene/α-olefin interpolymer, and having a density, d, in grams/cubic centimeter, wherein the numerical values of Re and d satisfying the following relationship when ethylene/α-olefin interpolymer being substantially free of a cross-linked phase:
   Re >1481-1629(d); or
(d) having a molecular fraction which elutes between 40°C and 130°C when fractionated using TREF, characterized in that the fraction having a molar comonomer content of at least 5 percent higher than that of a comparable random ethylene interpolymer fraction eluting between the same temperatures, wherein said comparable random ethylene interpolymer having the same comonomer(s) and having a melt index, density, and molar comonomer content (based on the whole polymer) within 10 percent of that of the ethylene/α-olefin interpolymer; or
(e) having a storage modulus at 25°C, G' (25°C), and a storage modulus at 100°C, G' (100°C), wherein the ratio of G' (25°C) to G' (100°C) being in the range of 1:1 to 9:1.

Such olefin block copolymer, e.g. ethylene/α-olefin interpolymer may also:
(a) have a molecular fraction which elutes between 40°C and 130°C when fractionated using TREF, characterized in that the fraction having a block index of at least 0.5 and up to 1 and a molecular weight distribution, M_{w}/Mₙ, greater than 1.3; or
(b) have an average block index greater than zero and up to 1.0 and a molecular weight distribution, M_{w}/Mₙ, greater than 1.3.

In one embodiment, matrix (18) may further comprise a blowing agent thereby facilitating the formation a foam material. In one embodiment, the matrix may be a foam, for example a closed cell foam. In another embodiment, matrix (18) may further comprise one or more fillers thereby facilitating the formation a microporous matrix, for example, via orientation, e.g. biaxial orientation, or cavitation, e.g. uniaxial or biaxial orientation, or leaching, i.e. dissolving the fillers. Such fillers include, but are not limited to, natural calcium carbonates, including chalks, calcites and marbles, synthetic carbonates, salts of magnesium and calcium, dolomites, magnesium carbonate, zinc carbonate, lime, magnesia, barium sulphate, barite, calcium sulphate, silica, magnesium silicates, talc, wollastonite, clays and aluminium silicates, kaolins, mica, oxides or hydroxides of metals or alkaline earths, magnesium hydroxide, iron oxides, zinc oxide, glass or carbon fiber or powder, wood fiber or powder or mixtures of these compounds.

The one or more functional filler materials (12) may be selected from the group consisting of gas, liquid, solid or combinations thereof.

The one or more phase change materials (12) may be any material suitable for a specific end-use application.

The functional filler materials (12) can include a mixture or blend of two or more substances. Functional filler materials (12) that can be used in conjunction with various embodiments of the invention include various organic and inorganic substances. The functional filler materials (12) include (1) Bioactive Fillers such as (self assembling) proteins, phosphate salts, silicate carbonate salts, hydroxyapatite, bio-active glasses, and/or porous ceramic spheres for controlled delivery; (2) Electrical and Magnetically Active Fillers such as carbon black, carbon nanotubes, carbon nanofibers, iron oxides, aluminum oxides, rare earth oxides, silicon micro and nano-particles, and/or metal micro and/or nano-particles, (3) Organic-Inorganic Hybrids such as surface property modification (wettability, scratch resistance, coefficient of friction, gloss), e.g. functionalized silanes, siloxanes, silica nanoparticles; reinforcement agents (stiffness and impact modification), e.g. silica nanoparticles, silica fumes, porous silica particles; rheology modifiers, e.g. glass microspheres, and/or silica particles and microspheres; (4) surface property modifiers such as solid lubricants (such as fluoropolymers, micas, graphites, fumed silica, hydrotalcite. magnesium oxide); and/or wettability promoters (such as amide, amine polymers, maleic anhydride, ethylene carbon monoxide, ethylene vinyl acetate, and ethylene acrylic acid grafted polymers); (5) flame retardants (solid and liquid) such as metal hydroxides, antimony oxide, ammonium polyphosphate, borate salts, low melting temperature glasses, and/or melamines.

In one embodiment, the functional filler material comprises one or more superabsorbent polymers. Such superabsorbent polymers are generally known, and include, but are not limited to, polyacrylamide copolymer, ethylene maleic anhydride copolymer, cross-linked carboxymethylcellulose, polyvinyl alcohol copolymers, cross-linked polyethylene oxide, and starch grafted copolymer of polyacrylonitrile. In one embodiment, superabsorbent polymers include those polymers made from the polymerization of acrylic acid blended with sodium hydroxide in the presence of an initiator to form a poly-acrylic acid sodium salt (sometimes referred to as sodium polyacrylate). Such superabsorbent polymers may be made via any method, for example, via suspension polymerization or solution polymerization.

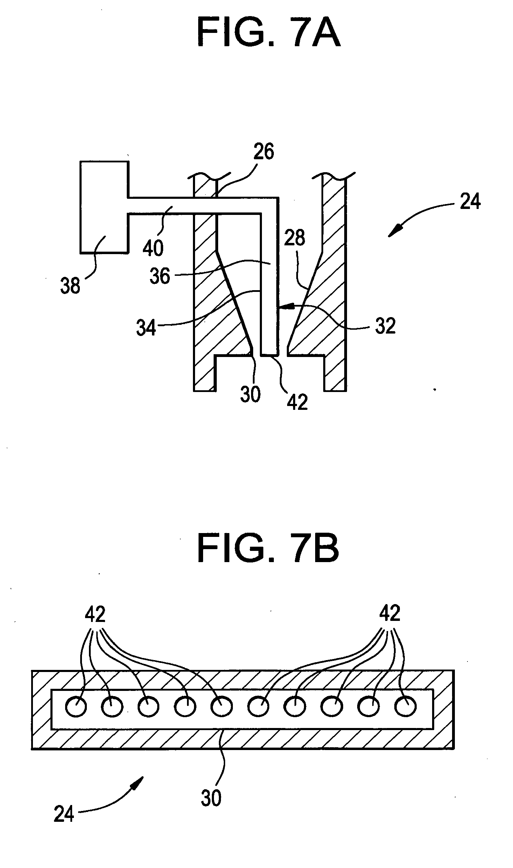

In production, the extrusion apparatus comprises screw extruder driven by a motor. Thermoplastic material is melted and conveyed to a die (24), as shown in Figures 7a and 7b. The molten thermoplastic material passes through die (24), as shown in Figures 7a and 7b, and is formed into the desired shape and cross section. Referring to Figures 7a and 7b, die (24) includes an entry portion (26), a convergent portion (28), and an orifice (30), which has a predetermined shape. The molten thermoplastic polymer enters entry portion (26) of the die (24), and is gradually shaped by the convergent portion (28) until the melt exits the orifice (30). The die (24) further includes injectors (32). Each injector (32) has a body portion (34) having a conduit (36) therein which is fluidly connected to a functional filler material source (38) by means of second conduit (40) passing through the walls of die (24) around which the molten thermoplastic material must flow to pass the orifice (30). The injector (30) further includes an outlet (42). The injector (32) is arranged such that the outlet (42) is located within the orifice (30). As the molten thermoplastic polymer exits the die orifice (30), one or more functional filler materials (12) is injected into the molten thermoplastic material thereby forming microcapillaries filled with one or more functional filler materials (12). In one embodiment, one or more functional filler materials (12) is continuously injected into the molten thermoplastic material thereby forming microcapillaries filled with one or more functional filler materials (12). In another embodiment, one or more functional filler materials (12) is intermittently injected into the molten thermoplastic material thereby forming microcapillaries filled with one or more functional filler materials (12) segments and void segments exhibiting foam like structures.

The microcapillary films or foams containing one or more functional filler materials according to the present invention may be used in absorption applications, selective chemical absorption in waste treatment, water absorption in food packaging, body fluid absorption for diagnostics, liquid absorption in hygiene applications, odors absorption and slow release applications.

One or more inventive microcapillary films or foams containing one or more functional filler materials may form one or more layers in a multilayer structure, for example, a laminated multilayer structure or a coextruded multilayer structure. The microcapillary films or foams containing one or more functional filler materials may comprise one or more parallel rows of microcapillaries (channels as shown in Fig. 3b). Channels (20) (microcapillaries) may be disposed any where in matrix (10), as shown in Figs. 3a-e.

## Claims

1. A film or foam having a first end and a second end and a length extending between the first and second ends and having a thickness smaller than the length, wherein said film or foam comprises:
(a) a matrix comprising a thermoplastic material,
(b) at least more than one channel disposed in parallel to the length in said matrix from the first end to the second end of said film, wherein said channels are at least 1 µm apart from each other, and wherein each of said channels have a diameter in the range of at least 1 µm and less than 1998 µm; and
(c) one or more functional filler materials inserted in said channels;
wherein the thickness is from 2 µm to 2000 µm; and
wherein the one or more functional filler materials are selected from the group consisting of bioactive fillers, electrical and/or magnetically active fillers, organic-inorganic hybrids, surface property modifiers, wettability promoters, solid and/or liquid flame retardants and superabsorbent polymers.

2. The film or foam of Claim 1, wherein said thermoplastic material is selected from the group consisting of polyolefin; polyamide; polyvinylidene chloride; polyvinylidene fluoride; polyurethane; polycarbonate; polystyrene; polyethylene vinylalcohol (PVOH), polyvinyl chloride, polylactic acid (PLA) and polyethylene terephthalate.

3. The film or foam of Claim 2, wherein said polyolefin is polyethylene or polypropylene.

4. The film or foam of Claim 2, wherein said polyamide is nylon 6.

5. The film or foam of Claim 1, wherein said one or more channels have a cross-sectional shape selected from the group consisting of circular, rectangular, oval, star, diamond, triangular, square and combinations thereof.

6. A multilayer structure comprising the film or foam of Claim 1.

7. An article comprising the film or foam of Claim 1.

## Patentansprüche

1. Eine Folie oder ein Schaumstoff mit einem ersten Ende und einem zweiten Ende und einer Länge, die sich zwischen dem ersten und dem zweiten Ende erstreckt, und mit einer Dicke, die geringer als die Länge ist, wobei die Folie oder der Schaumstoff Folgendes beinhaltet:
(a) eine Matrix, beinhaltend ein thermoplastisches Material,
(b) mindestens mehr als einen Kanal, der in der Matrix von dem ersten Ende zu dem zweiten Ende der Folie parallel zu der Länge angeordnet ist, wobei die Kanäle mindestens 1 µm voneinander mit Abstand angeordnet sind, und wobei jeder der Kanäle einen Durchmesser im Bereich von mindestens 1 µm und weniger als 1998 µm aufweist; und
(c) ein oder mehrere funktionelle in die Kanäle eingeführte Füllmaterialien;
wobei die Dicke von 2 µm bis 2000 µm beträgt; und
wobei das eine oder die mehreren funktionellen Füllmaterialien aus der Gruppe ausgewählt sind, bestehend aus bioaktiven Füllstoffen, elektrischen und/oder magnetisch aktiven Füllstoffen, organisch-anorganischen Hybriden, Modifikatoren der Oberflächeneigenschaft, Benetzbarkeitsförderern, festen und/oder flüssigen Flammschutzmitteln und superabsorbierenden Polymeren.

2. Folie oder Schaumstoff gemäß Anspruch 1, wobei das thermoplastische Material ausgewählt ist aus der Gruppe, bestehend aus Polyolefin; Polyamid; Polyvinylidenchlorid; Polyvinylidenfluorid; Polyurethan; Polycarbonat; Polystyrol; Polyethylenvinylalkohol (PVOH), Polyvinylchlorid, Polymilchsäure (PLA) und Polyethylenterephthalat.

3. Folie oder Schaumstoff gemäß Anspruch 2, wobei das Polyolefin Polyethylen oder Polypropylen ist.

4. Folie oder Schaumstoff gemäß Anspruch 2, wobei das Polyamid Nylon 6 ist.

5. Folie oder Schaumstoff gemäß Anspruch 1, wobei der eine oder die mehreren Kanäle eine Querschnittsform aufweisen, die ausgewählt ist aus der Gruppe, bestehend aus kreisförmig, rechteckig, oval, sternförmig, rautenförmig, dreieckig, quadratisch und Kombinationen davon.

6. Eine Mehrschichtenstruktur, beinhaltend die Folie oder den Schaumstoff gemäß Anspruch 1.

7. Ein Artikel, beinhaltend die Folie oder den Schaumstoff gemäß Anspruch 1.

## Revendications

1. Un film ou une mousse ayant une première extrémité et une deuxième extrémité et une longueur s'étendant entre les première et deuxième extrémités et ayant une épaisseur plus petite que la longueur, ledit film ou ladite mousse comprenant :
(a) une matrice comprenant un matériau thermoplastique,
(b) au moins plus d'un canal disposé en parallèle par rapport à la longueur dans ladite matrice de la première extrémité à la deuxième extrémité dudit film, lesdits canaux étant au moins espacés d'1 µm les uns des autres, et chacun desdits canaux ayant un diamètre compris dans la gamme d'au moins 1 µm et de moins de 1 998 µm; et
(c) un ou plusieurs matériaux de charge fonctionnels insérés dans lesdits canaux ; l'épaisseur allant de 2 µm à 2 000 µm ; et
ce ou ces matériaux de charge fonctionnels étant sélectionnés dans le groupe constitué de charges bioactives, de charges électriques et/ou magnétiquement actives, d'hybrides organiques-inorganiques, de modificateurs de propriété de surface, de promoteurs de mouillabilité, d'agents ignifugeants solides et/ou liquides et de polymères superabsorbants.

2. Le film ou la mousse de la revendication 1, ledit matériau thermoplastique étant sélectionné dans le groupe constitué de polyoléfine ; polyamide ; chlorure de polyvinylidène ; fluorure de polyvinylidène ; polyuréthane ; polycarbonate ; polystyrène ; polyéthylène vinylalcool (PVOH), chlorure de polyvinyle, acide polylactique (PLA) et polyéthylène téréphtalate.

3. Le film ou la mousse de la revendication 2, ladite polyoléfine étant du polyéthylène ou du polypropylène.

4. Le film ou la mousse de la revendication 2, ledit polyamide étant du nylon 6.

5. Le film ou la mousse de la revendication 1, ce ou ces dits canaux ayant une forme en coupe transversale sélectionnée dans le groupe constitué de circulaire, rectangulaire, ovale, en étoile, en losange, triangulaire, carrée et de combinaisons de celles-ci.

6. Une structure multicouche comprenant le film ou la mousse de la revendication 1.

7. Un article comprenant le film ou la mousse de la revendication 1.
